## Europäisches Patentamt
## European Patent Office
## Office européen des brevets

(11) Veröffentlichungsnummer: **0 237 886 B1**

# EUROPÄISCHE PATENTSCHRIFT

(45) Veröffentlichungstag der Patentschrift:
06.02.91 Patentblatt 91/06

(51) Int. Cl.⁵: **H03C 1/20**

(21) Anmeldenummer: 87103215.7

(22) Anmeldetag: 06.03.87

(54) Verfahren und Anordnung zur Anodenmodulation einer Senderendstufenröhre.

(30) Priorität: 13.03.86 DE 3608358

(43) Veröffentlichungstag der Anmeldung:
23.09.87 Patentblatt 87/39

(45) Bekanntmachung des Hinweises auf die
Patenterteilung:
06.02.91 Patentblatt 91/06

(84) Benannte Vertragsstaaten:
CH DE FR GB LI

(56) Entgegenhaltungen:
FR-A- 916 522
FR-A- 955 149
FR-A- 960 979

(73) Patentinhaber: Licentia
Patent-Verwaltungs-GmbH
Theodor-Stern-Kai 1
D-6000 Frankfurt/Main 70 (DE)

(72) Erfinder: Weber, Klaus, Dipl.-Ing.
Grüntaler Strasse 8
D-1000 Berlin 65 (DE)

(74) Vertreter: Schulze, Harald Rudolf, Dipl.-Ing.
Licentia Patent-Verwaltungs-GmbH
Theodor-Stern-Kai 1
D-6000 Frankfurt/Main 70 (DE)

## Beschreibung

Die Erfindung betrifft ein Verfahren und eine Anordnung zur Anodenmodulation einer Senderendstufenröhre nach dem Oberbegriffen der Patentansprüche 1 bzw. 3.

Bei einem Hochleistungssender, z.B. einem 100 kW-Sender, erfolgt an der Senderendstufenröhre eine Anodenmodulation, da diese einen hohen Wirkungsgrad besitzt. Bei der Anodenmodulation wird die niederfrequente Modulationsspannung, z.B. ein Niederfrequenz (NF)-Signal mit einer Bandbreite von 10 kHz, der Anodengleichspannung, z.B. 12 kV, der Senderendstufenröhre überlagert, während an deren Steuergitter ein unmoduliertes Hochfrequenz-Trägersignal, z.B. mit einer Frequenz von 30 MHz, anliegt. Dadurch entsteht an der Anode ein amplitudenmoduliertes Trägersignal, daS einer Senderantenne zugeführt wird.

Zur Erhöhung des Wirkungsgrades und/oder zur Vermeidung von störenden Verzerrungen des Ausgangssignales ist es zweckmäßig, bei der Senderendstufe eine Mitmodulation durchzuführen. Dabei wird die Senderendstufenröhre, z.B. eine Tetrode mit einer maximalen Leistung von 100 KW zusätzlich steuer- oder schirmgitterseitig mit dem zu übertragenden NF-Signal (mit-) moduliert. Dieses ist z.B. dadurch möglich, daß der zugehörigen (Treiber-)Vorstufe ein entsprechendes Mitmodulationssignal zugeführt wird.

Bei amplitudenmodulierten Sendern, bei denen die Modulationsspannung mit einem Modulationstransformator der Anodengleichspannung der Hochfrequenzendstufenröhre überlagert wird, wird die zur Mitmodulation notwendige Spannung an einer separaten Wicklung des Modulationstransformators abgegriffen und entweder der Steuergitter- bzw. der Schirmgitterspannung oder der Anodenspannung der Treiberstufenröhre überlagert, um die Mitmodulation in den Gittern der Endstufenröhre bzw. in der Anode der Treiberröhre zu erreichen.

Eine derartige Anordnung hat den Nachteil, daß der in der Anodenzuleitung der Senderendstufenröhre liegende Modulationstransformator technisch aufwendig und daher kostenungünstig ist. Zur Vermeidung dieses Nachteils sind NF-Modulationsschaltungen bekannt, die keinen derartigen Modulationstransformator benötigen.

Der Erfindung liegt daher die Aufgabe zugrunde, ein gattungsgemäßes Verfahren sowie eine gattungsgemäße Anordnung anzugeben, die eine Mitmodulation ermöglichen, die im wesentlichen unabhängig ist von dem gewählten NF-Modulator für die Anodenspannung der Senderendstufenröhre.

Diese Aufgabe wird bei verfahren und Anordnung die eingangs genannter Art gelöst durch die in den kennzeichnenden Teilen der Patentansprüche 1 und 3 angegebenen Merkmale. Vorteilhafte Ausgestaltungen und/oder Weiterbildungen sind den Unteransprüchen entnehmbar.

Ein erster Vorteil der Erfindung besteht darin, daß derzeit kostengünstige sowie zuverlässige elektrische Bauelemente verwendbar sind, die lediglich eine geringe Spannungsfestigkeit besitzen.

Ein zweiter Vorteil besteht darin, daß für die Mitmodulations-Schaltung lediglich wenige passive elektrische Bauelemente erforderlich sind, so daß eine kostengünstige sowie zuverlässige Schaltungsanordnung herstellbar ist.

Die Erfindung beruht darauf, daß es bei einer anodenmodulierten Senderendstufenröhre, z.B. einer Triode oder einer Tetrode, möglich ist, in deren Gitterzuleitungen eine Impedanz zu legen, so daß daran eine niederfrequente Wechselspannung entsteht. Es wird nun zumindest ein Teil dieser Wechselspannung der (HF)-Vorstufe zugeführt, welche das Steuergitter der Senderendstufenröhre ansteuert.

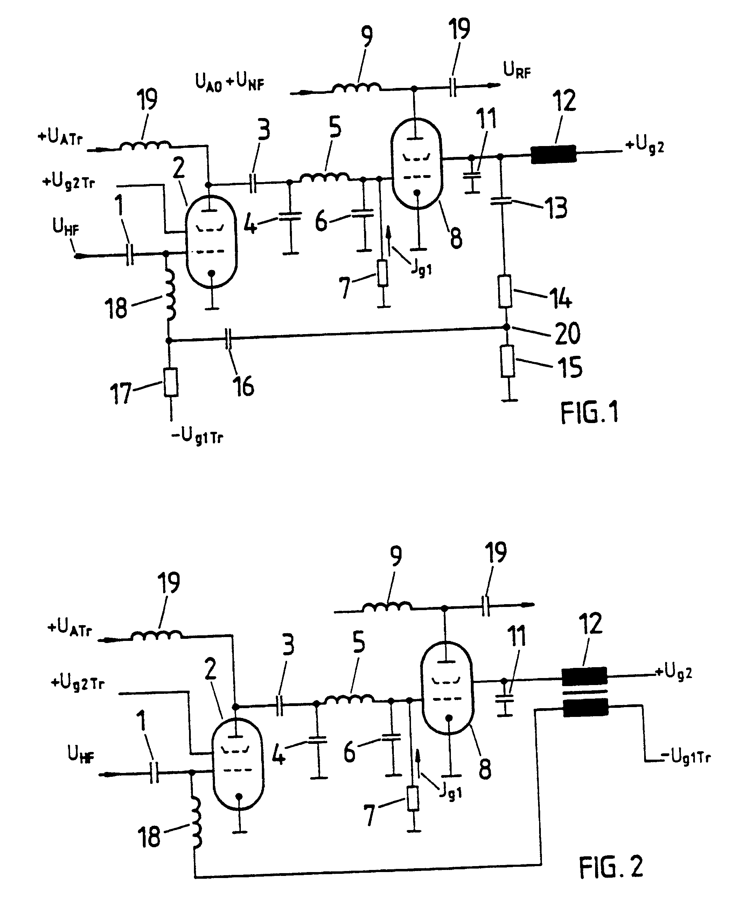

Die Erfindung wird im folgenden anhand von Ausführungsbeispielen unter Bezugnahme auf eine schematische Zeichnung näher erläutert. Die Figuren 1 bis 4 zeigen schematisch dargestellte Schaltungsanordnungen von Ausführungsbeispielen. Es sind lediglich diejenigen elektrischen Bauelemente dargestellt, die zur Erläuterung der Erfindung notwendig sind.

Fig. 1 zeigt eine Anordnung, bei welcher die Senderendstufenröhre 8 als Tetrode ausgebildet ist und eine beispielhafte Leistung von 500 kW besitzt.

Über einen ersten Blockkondensator 1 wird eine hochfrequente Trägerspannung $U_{HF}$, z.B. mit der eingangs erwähnten Frequenz von 30 MHz, an das Steuergitter der Treiberröhre 2 gelegt, z.B. eine Tetrode mit einer Leistung von 100 kW. An der Treiberröhre 2 liegt eine Schirmgitterspannung $+U_{g2Tr}$ von z.B. 800 V sowie eine Anodengleichspannung $+U_{ATr}$ von z.B. 6 kV, die über eine Hochfrequenz (HF-) Drossel 19 mit einer Induktivität von z.B. 20 µH zugeführt wird. Die verstärkte Hochfrequenzleistung wird an der Anode der Treiberröhre 2 abgenommen und über einen zweiten Blockkondensator 3 sowie einen Gitterkreis, bestehend aus den einseitig an Masse liegenden Kondensatoren 4, 6 sowie einer dazwischengeschalteten Induktivität 5, an das Steuergitter der Senderendstufenröhre 8 geleitet. Das Steuergitter erhält die erforderliche Gittervorspannung von z.B. –600 V durch einen Spannungsabfall ein einem Vorwiderstand 7 von z.B. 120 Ohm, der zwischen dem Steuergitter und Masse angeschlossen ist und der von einem Gitterstrom $I_{g1}$ von z.B. 5 A durchflossen wird. Die Anodenspannung, die sich aus einer Anodengleichspannung $U_{AO}$ von z.B. 12 kV und einer dieser überlagerten und zu übertragenden Niederfrequenzspannung $U_{NF}$ zusammensetzt, wird über eine Anodendrossel 9 von z.B. 10 µH der Anode der Senderendstufenröhre 8 zugeführt. Die modulierte Hochfrequenzspannung $U_{RF}$ wird an der Anode über einen dritten Blockkondensator 10

ausgekoppelt und nachfolgenden nicht dargestellten (Senderantennen-) Schwingkreisen zugeleitet. Bei der Senderendstufenröhre 8 liegt das Schirmgitter an einer Schirmgittergleichspannung $+U_{g2}$ von z.B. +1,1 kV, die über eine Mitmodulationsdrossel 12 von z.B. 3 H zugeführt wird. Das Schirmgitter liegt hochfrequenzmäßig an Masse über einen Siebkondensator 11 von z.B. 10 nF.

An dem Schirmgitter entsteht daher bei der Anodenmodulation eine niederfrequente Spannung, deren Wechselspannungsanteil über einen vierten Blockkondensator 13 von z.B. 6 µF an einen aus den ohmschen Widerständen 14 und 15, z.B. 5kOhm bzw. 330 Ohm, bestehenden Spannungsteiler gelangt, dessen einer Anschluß mit Masse verbunden ist. Der an dem Widerstand 15 entstehende Wechselspannungsanteil wird über einen fünften Blockkondensator 16, z.B. 100 µF, der Gittergleichspannung $-U_{g1Tr}$ von z.B. –120 V überlagert. Der Gittervorwiederstand 7 besitzt einen Wert von z.B. 4kOhm. Gittergleichspannung $-U_{g1Tr}$ und der überlagerte Wechselspannungsanteil werden über eine HF-Drossel 18 von z.B. 30 µH dem Steuergitter der Treiberröhre 2 zugeführt. Diese wird dadurch gitterseitig zusätzlich mit einer NF-Spannung moduliert. Durch die entstehende Mitmodulation sind Modulationsverzerrungen von kleiner 3% erreichbar.

Fig. 2 zeigt ein Ausführungsbeispiel, bei welchem lediglich die in Fig. 1 dargestellten Bauelemtne 12 bis 17 durch eine als Transformator ausgebildete Modulationsdrossel 12 ersetzt sind. Bei diesem Transformator wirkt die Primärseite in der beschriebenen Weise als Mitmodulationsdrossel. Das entstehende niederfrequente Mitmodulationssignal wird in der Sekundärseite der Steuergittergleichspannung $-U_{g1Tr}$ überlagert und über die HF-Drossel 18 dem Steuergitter der Treiberröhre 2 zugeführt.

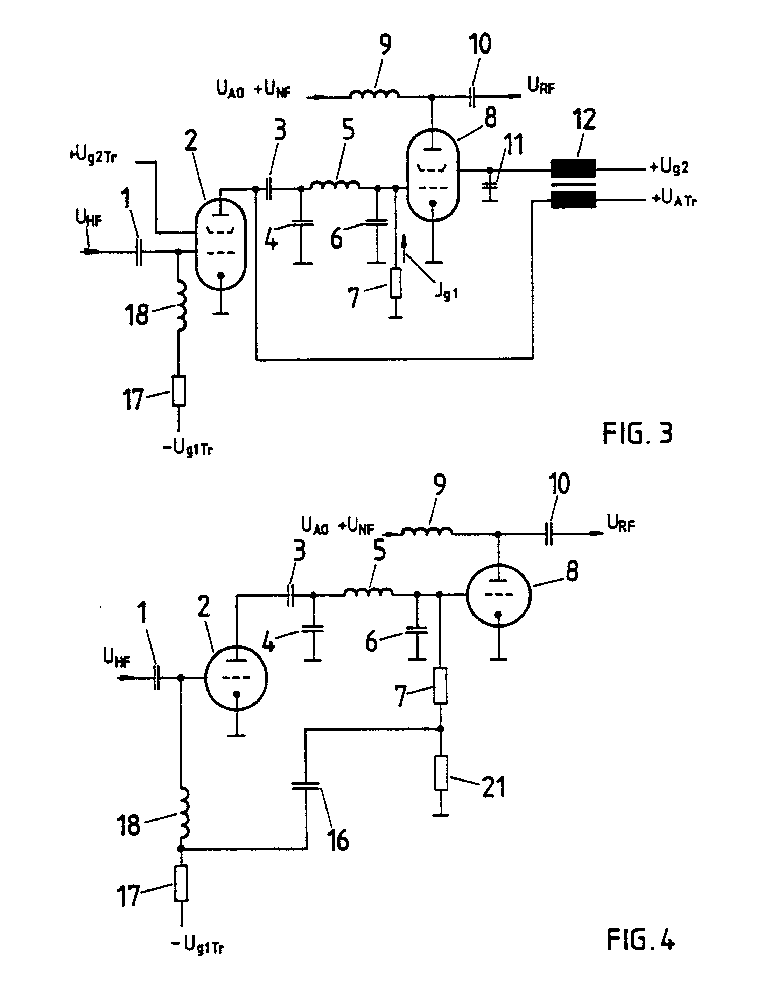

Das Ausführungsbeispiel gemäß Fig. 3 unterscheidet sich von demjenigen der Fig. 2 dadurch, daß das in der als Transformator ausgebildeten Mitmodulationsdrossel 12 entstehende Mitmodulationssignal in der Sekundärseite der Anodengleichspannung $+U_{ATR}$ der Treiberröhre 2 überlagert wird, so daß dort ebenfalls eine Anodenmodulation vorhanden ist. Bei der Treiberröhre 2 enthält das Steuergitter die erforderliche Vorspannung $-U_{g1Tr}$ über den Vorwiderstand 17 sowie die HF-Drossel 18.

Das Ausführungsbeispiel gemäß Fig. 4 unterscheidet sich von demjenigen der Fig. 1 dadurch, daß Trioden als Treiber- und Endstufenröhre verwendet werden. An der Reihenschaltung der Widerstände 7 und 21 fällt die Mitmodulationsspannung ab. Ein Teil dieser Mitmodulationsspannung wird am Widerstand 21 abgegriffen und der Gittergleichspannung der Treiberröhre überlagert. Durch diese gitterseitige Überlagerung wird die Treiberstufe mitmoduliert.

Die Erfindung ist nicht auf die beschriebenen Ausführungsbeispiele beschränkt, sondern sinngemäß auf weitere anwenwendbar. Beispielsweise ist es möglich, die Treiberröhre 2 als Pentode auszubilden.

## Ansprüche

1. Verfahren zur Anodenmodulation einer Senderendstufenröhre, bei welchem ein Mitmodulationssignal erzeugt wird, das einer Treiberstufe zugeführt wird, welche die Senderendstufenröhre ansteuert, insbesondere für einen Hochleistungssender, dadurch gekennzeichnet,
   - daß an einem Gitteranschluß der Senderendstufenröhre (8) eine Impedanz (11, 12, 7, 21) angebracht wird derart, daß daran ein dem Modulationssignal entsprechendes Mitmodulationssignal entsteht, und
   - daß zumindest ein Teil dieses Mitmodulationssignals der Treiberstufe (2) zugeführt wird.

2. Verfahren zur Anodenmodulation nach Anspruch 1, dadurch gekennzeichnet, daß das Modulationssignal in einem Freqquenzbereich von 40 Hz bis 10 kHz liegt und daß das Mitmodulationssignal in einem Frequenzbereich von 40 Hz bis 10 kHz liegt.

3. Anordnung zur Anodenmodulation einer Senderendstufenröhre, bei welcher ein Mitmodulationssignal erzeugt wird, das einer Treiberstufe zugeführt wird, welche die Senderendstufenröhre ansteuert, insbesondere für einen Hochleistungssender, dadurch gekennzeichnet,
   - daß die Senderendstufenröhre (8) als Tetrode ausgebildet ist, deren Schirmgitter über eine Mitmodulationsdrossel (12) an eine Schirmgitterspannung $(+U_{g2})$ gelegt ist,
   - daß das Schirmgitter über einen Siebkondensator (11) mit dem Masseanschluß verbunden ist derart, daß an dem Siebkondensator (11) das Mitmodulationssignal entsteht,
   - daß parallel zu dem Siebkondensator (11) ein Wechselspannungsteiler (13, 14, 15) geschaltet ist und
   - daß ein Abgreifpunkt (20) des Wechselspannungsteilers (13, 14, 15) über einen Koppelkondensator (16) sowie eine Hochfrequenzdrossel (18) mit der Steuergitter der Treiberröhre (2) verbunden ist, an welchem ein unmoduliertes Trägersignal $(U_{HF})$ anliegt.

4. Anordnung zur Anodenmodulation nach Anspruch 3, dadurch gekennzeichnet,
   - daß die Senderendstufenröhre (8) als Tetrode ausgebildet ist, deren Schirmgitter an eine Schirmgitterspannung $(+U_{g2})$ gelegt ist über und zwar eine Niederfrequenzdrossel (12), die als Niederfrequenzübertrager ausgebildet ist, dessen Sekundärwicklung einerseits an einer Steuergitterspannung $(U_{g1Tr})$ für die Treiberröhre (2) liegt und andererseits über eine Hochfrequenzdrossel (18) mit dem Steuergitter der Treiberröhre (2) verbunden ist, an welchem ein unmoduliertes Trägersignal (U_{HF}) anliegt, und

– daß das Schirmgitter der Senderendstufenröhre (8) über einen Siebkondensator (11) mit dem Masseanschluß verbunden ist derart, daß in der Niederfrequenzdrossel (12) das Mitmodulationssignal entsteht.

5. Anordnung zur Anodenmodulation nach Anspruch 3 oder Anspruch 4, dadurch gekennzeichnet,

– daß die Senderendstufenröhre (8) als Tetrode ausgebildet ist, deren Schirmgitter an eine Schirmgitterspannung (+U_{g2}) gelegt ist über und zwar eine Niederfrequenzdrossel (12), die als Niederfrequenzübertrager ausgebildet ist, dessen Sekundärwicklung einerseits an einer Anodenspannung (+U_{ATr}) für die Treiberröhre (2) liegt und andererseits mit der Anode der Treiberröhre (2) verbunden ist, und

– daß das Schirmgitter der Senderendstufenröhre (8) über einen Siebkondensator (11) mit dem Massenanschluß verbunden ist derart, daß in der Niederfrequenzdrossel (12) das Mitmodulationssignal entsteht.

## Claims

1. Method for the anode modulation of a transmitter output stage valve, in which a co-modulation signal is produced, which is fed to a driver stage which drives the transmitter output stage valve, in particular for a high power transmitter, characterised thereby,

– that an impedance (11, 12 ; 7, 21) is arranged in such a manner at a grid connection of the transmitter output stage valve (8) that a co-modulation signal corresponding to the modulation signal arises thereat and

– that at least a part of this co-modulation signal is fed to the driver stage (2).

2. Method for the anode modulation according to claim 1, characterised thereby, that the modulation signal lies in a frequency range of 40 hertz to 10 kilohertz and that the co-modulation signal lies in a frequency range of 40 hertz to 10 kilohertz.

3. Arrangement for the anode modulation of a transmitter output stage valve, in which a co-modulation signal is produced, which is fed to a driver stage which drives the transmitter output stage valve, in particular for a high power transmitter, characterised thereby,

– that the transmitter output stage valve (8) is constructed as tetrode, the screen grid of which is applied by way of a comodulation choke (12) to a screen grid voltage (+U_{g2}),

– that the screen grid is connected by way of a filter capacitor (11) with the ground connection in such a manner that the co-modulation signal arises at the filter capacitor (11),

– that an alternating voltage divider (13, 14, 15) is connected in parallel with the filter capacitor (11) and

– that a tap (20) of the alternating voltage divider (13, 14, 15) is connected by way of a coupling capacitor (16) as well as a high-frequency choke (18) with the control grid of the driver valve (2), at which grid an unmodulated carrier signal (U_{HF}) is present.

4. Method for the anode modulation according to claim 3, characterised thereby,

– that the transmitter output stage valve (8) is constructed as tetrode, the screen grid of which is applied to a screen grid voltage (+U_{g2}), and namely by way of a low-frequency choke (12), which is constructed as low-frequency transformer, the secondary winding of which by the one end lies at a control grid voltage (U_{g1Tr}) for the driver valve (2) and by the other end is connected by way of a high-frequency choke (18) with the control grid of the driver valve (2), at which an unmodulated carrier signal (U_{HF}) is present, and

– that the screen grid of the transmitter output stage valve (8) is connected by way of a filter capacitor (11) with the ground connection in such a manner that the co-modulation signal arises in the low-frequency choke (12).

5. Method for the anode modulation according to claim 3 or claim 4, characterised thereby,

– that the transmitter output stage valve (8) is constructed as tetrode, the screen grid of which is applied to a screen grid voltage (+U_{g2}), and namely by way of a low-frequency choke (12) which is constructed as low-frequency transformer, the secondary winding of which by the one end lies at an anode voltage (+U_{ATr}) for the driver valve (2) and by the other end is connected with the anode of the driver valve (2), and

– that the screen grid of the transmitter output stage valve (8) is connected by way of a filter capacitor (11) with the ground connection in such a manner that the co-modulation signal arises in the low-frequency choke (12).

## Revendications

1. Procédé de modulation d'anode d'un tube d'étage final d'émetteur, dans lequel on engendre un signal de comodulation qui est transmis à un étage d'attaque qui commande le tube de l'étage final d'émetteur, notamment pour un émetteur de grande puissance, caractérisé

– par le fait qu'à la borne de grille du tube (8) de l'étage final d'émetteur est appliquée une impédance (11, 12, 7, 21) telle qu'il s'y forme un signal de comodulation correspondant au signal de modulation, et
– par le fait qu'au moins une partie de ce signal de comodulation est appliquée à l'étage d'attaque (2).

2. Procédé de modulation d'anode selon revendication 1, caractérisé par le fait que le signal de modulation est compris dans une plage de fréquence de 40 Hz à 10 kHz, et par le fait que le signal de comodulation se situe dans une plage de fréquence de 40 Hz à 10 kHz.

3. Agencement de modulation d'anode d'un tube d'étage final d'émetteur, dans lequel est engendré un signal de comodulation qui est transmis à un étage d'attaque, lequel commande le tube d'étage de sortie de l'émetteur, notamment pour un émetteur de grande puissance, caractérisé
– par le fait que le tube (8) d'étage de sortie de l'émetteur est réalisé en tant que tétrode dont la grille-écran est à une tension de grille-écran (+$U_{g2}$) par l'intermédiaire d'une bobine d'arrêt pour comodulation (12),
– par le fait que la grille-écran est reliée à la borne de masse par l'intermédiaire d'un condensateur-filtre (11), de manière telle que le signal de comodulation soit présent au condensateur-filtre (11),
– par le fait qu'un diviseur de tension alternative (13, 14, 15) est monté en parallèle du condensateur-filtre (11), et
– par le fait qu'un point de prise (20) du diviseur de tension alternative (13, 14, 15) est relié, par l'intermédiaire d'un condensateur de couplage (16) ainsi que par l'intermédiaire d'une bobine d'arrêt haute fréquence (18), à la grille de commande du tube d'attaque (2) à laquelle est présent un signal de porteuse non modulé ($U_{HF}$).

4. Agencement pour modulation d'anode selon revendication 3, caractérisé
– par le fait que le tube (8) de l'étage final d'émetteur est réalisé en tant que tétrode à la grille-écran de laquelle est appliquée une tension de grille-écran (+$U_{g2}$), cela par l'intermédiaire d'une bobine d'arrêt basse fréquence (12) réalisée en tant que transformateur basse fréquence dont l'enroulement secondaire est d'une part appliqué à une tension de grille de commande ($U_{g1Tr}$) pour le tube d'attaque (2) et, d'autre part, relié, par l'intermédiaire d'une bobine d'arrêt haute fréquence (18), à la grille de commande du tube d'attaque (2) à laquelle est appliqué un signal de porteuse non modulé ($U_{HF}$), et
– par le fait que la grille-écran du tube (8) de l'étage final d'émetteur est reliée, par un condensateur-filtre (11), à la borne de masse de manière que le signal de comodulation s'établisse dans la bobine d'arrêt basse fréquence (12).

5. Agencement pour modulation d'anode selon revendication 3 ou revendication 4, caractérisé
– par le fait que le tube (8) de l'étage final de l'émetteur est réalisé en tant que tétrode à la grille-écran duquel est appliquée une tension de grille-écran (+$U_{g2}$), cela par une bobine d'arrêt basse fréquence (12) qui est réalisée en tant que transformateur basse fréquence dont l'enroulement secondaire est d'une part appliqué à une tension d'anode (+$U_{ATr}$) pour le tube d'attaque (2) et, d'autre part, relié à l'anode du tube d'attaque (2), et
– par le fait que la grille-écran du tube (8) de l'étage final de l'émetteur est reliée, via un condensateur-filtre (11), à la borne de masse de manière telle que le signal de comodulation s'établisse dans la bobine d'arrêt basse fréquence (12).

FIG.1

FIG. 2

FIG. 3

FIG. 4